# EUROPÄISCHE PATENTSCHRIFT

(11) **EP 2 415 113 B1**
(45) Veröffentlichungstag und Bekanntmachung des Hinweises auf die Patenterteilung: **11.11.2015**
(21) Anmeldenummer: 10712053.7
(22) Anmeldetag: 29.03.2010
(51) Int. Cl.: H01M 8/10, H01M 8/18, H01M 10/39

(54) **VERFAHREN ZUR SPEICHERUNG UND TRANSPORT ELEKTROCHEMISCHER ENERGIE**
METHOD FOR STORING AND TRANSPORTING ELECTROCHEMICAL ENERGY
PROCÉDÉ D'ACCUMULATION ET DE TRANSPORT D'ÉNERGIE ÉLECTRIQUE

(30) Priorität: 01.04.2009 EP 09157056
(43) Veröffentlichungstag der Anmeldung: 08.02.2012
(73) Patentinhaber: BASF SE, 67056 Ludwigshafen (DE)
(72) Erfinder: UEBLER, Christoph, 67308 Lautersheim (DE); BENDER, Dietmar, 67459 Böhl-Iggelheim (DE); EHRENSTEIN, Moritz, NJ 07940 Madison (US); FISCHER, Andreas, 64646 Heppenheim (DE); HUBER, Günther, 67071 Ludwigshafen (DE)
(86) Internationale Anmeldenummer: PCT/EP2010/054123
(87) Internationale Veröffentlichungsnummer: WO 2010/112466

(56) Entgegenhaltungen:
- JP-A- 2001 118 598
- US-A- 3 533 848
- US-A- 4 049 885

## Beschreibung

Die Erfindung betrifft ein Verfahren zur Speicherung und zum Transport elektrochemischer Energie mit einem elektrochemischen Kraftwerk auf Basis von Alkalimetall, insbesondere Natrium, und Schwefel, in der die beiden Reaktanden der elektrochemischen Reaktion aus Vorratsbehältern in einen elektrochemischen Reaktor strömen und die Produkte nach erfolgter elektrochemischer Reaktion abgeführt werden.

Die Erzeugung elektrochemischer Energie ist im Falle fossiler Kraftwerke mit der Erzeugung von CO₂ verbunden und hat damit erheblichen Einfluss auf den Treibhauseffekt. Energieerzeugung auf Basis regenerativer Energieträger, z. B. Wind, Solar, Geothermie oder Wasserkraft vermeidet diesen Nachteil. Diese regenerativen Energieträger sind zeitlich jedoch nicht beliebig lastganggerecht verfügbar. Außerdem differiert ggf. der Standort der Energieerzeugung vom Ort des Energiebedarfs. Um diesen systembedingten Nachteil zu kompensieren ist eine Speicherung, Pufferung und ggf. auch ein Transport der erzeugten Energie erforderlich.

Die Energie aus erneuerbaren Quellen, wie Windrädern, Solaranlagen fällt nicht kontinuierlich an. Bedarf und Verfügbarkeit stehen nicht im Einklang. Ein ausschließlich auf erneuerbaren Energien basierendes und dennoch stabiles Stromnetz kann es unter diesen Rahmenbedingungen nicht geben. Es besteht der Bedarf diese Schwankungen durch kostengünstige und energieeffiziente Systeme mit einem hohen Wirkungsgrad auszugleichen und zu puffern.

In vielen dünn besiedelten Regionen der Erde, z. B. Sahara, Island oder "off-shore" besteht das Potential, aufgrund der geographischen, klimatischen bzw. geologischen Rahmenbedingungen überaus effizient aus Wind, Sonne bzw. geothermischer Wärme elektrischen Strom via Windkraft, Solaranlagen bzw. geothermischen Kraftwerk zu erzeugen. Heute mangelt es jedoch an technischen Verfahren, diese Energie in Regionen mit hohem Verbrauch zu transportieren. Traditionelle Leitungssysteme sind durch Netzverluste und Kosten des Netzausbaus limitiert. Die Wasserstofftechnologie, bei der vor Ort erzeugte elektrische Energie in Wasserstoff umgewandelt und anschließend in einer Brennstoffzelle in Strom umgewandelt wird, ist mit einem Gesamtwirkungsgrad von rund 20 % unattraktiv, da Transport und Verflüssigung des Wasserstoffs einen Großteil der Energie verbrauchen.

Die Speicherung großer Mengen elektrischer Energie stellt genauso wie der Transport elektrischer Energie über große Distanzen ein bis heute nur unbefriedend gelöstes Problem dar. Zur Speicherung elektrischer Energien werden derzeit im technischen Maßstab Pumpspeicherkraftwerke verwendet, in denen die potentielle Energie der geodätischen Höhendifferenz des Wassers zur Umwandlung in Strom genutzt wird. Der Aufbau solcher Pumpspeicherkraftwerke ist durch landschaftliche und ökologische Rahmenbedingungen jedoch limitiert. Druckspeicherkraftwerke, in denen die Kompression von Luft zu Energiespeicherung genutzt wird, sind aufgrund ihres vergleichsweise geringen Wirkungsgrades limitiert. Auch andere Formen der Energiespeicherungen wie Superkondensator oder das Schwungrad adressieren andere Zielmärkte (Kurzzeitspeicher). Am nächsten kommen diesem Anspruch Batterien, welche in verschiedenen Konzepten technisch realisiert wurden.

Aus der DE-A-2635900 ist eine Batterie bekannt, die mindestens ein geschmolzenes Alkalimetall als Anode und einen kathodischen Reaktionsteilnehmer, welcher elektrochemisch umkehrbar reaktionsfähig ist mit dem anodischen Reaktionsteilnehmer, enthält. Der kathodische Reaktionsteilnehmer besteht aus geschmolzenen Polysulfidsalzen oder einer zweiphasigen Masse aus geschmolzenem Schwefel und mit geschmolzenem Schwefel gesättigten Polysulfidsalzen. Diese Batterie weist weiterhin Kationendurchlässige Sperrschichten für den Massenflüssigkeitstransport zwischen der anodischen und der kathodischen Reaktionszone auf.

Aus der DE-A-2610222 ist eine aus mehreren Schwefel-Natrium-Zellen bestehende Batterie bekannt, wobei jede Zelle 1) ein kathodisches Abteil mit einem bei Betriebstemperatur flüssigen kathodischen Reaktionsstoff 2) aus Schwefel, Phosphor oder Selen oder alkalischen Salzen dieser Elemente, mindestens ein Feststoffelektrolytrohr, das bei der Betriebstemperatur flüssigen anodischen Reaktionsstoff aus einem Alkalimetall, insbesondere Natrium aufweist, sowie einen anodischen Behälter 3), der eine Reserve des anodischen Reaktionsstoffs enthält.

Aus der EP-A-116690 ist bekannt, mehrere Natriumschwefelbatterien als Module für ein Energiespeichersystem zusammenzuschalten.

All diesen Batterien ist gemeinsam, dass sie als geschlossene Systeme in ihrer Energiespeicherung durch die Menge der in Batterie enthaltenen Reaktanden (Redoxpartner) begrenzt sind. Diese Begrenzung wurde durch die Flow Batterie behoben. Basis dieses Batteriekonzepts sind flüssige, aus Lösungsmittel und Metallsalz bestehende Elektrolyten. Das begrenzte Vorratsvolumen der klassischen Batterie wird durch zweite Vorratsbehälter mit den Reaktanden vergrößert.

Aus der DE-A-2927868 ist eine Flow Batterie zur Speicherung und Freisetzung von elektrischer Energie in einer elektrochemischen Zelle mit einem Anoden- und einem Kathodenabteil bekannt, die durch eine semipermeable Ionenaustauschermembran voneinander getrennt sind, wobei man das Anodenabteil mit einer so genannten Anolytlösung, einer oxidierbaren Verbindung, die im Wesentlichen in der Anolytlösung gelöst bleibt und aus ihrer oxidierten Form wieder reduziert werden kann, beschickt, die oxidierte Anolytlösung aus dem Anolytabteil entfernt und die oxidierte Anolytlösung speichert. Gleichzeitig beschickt man das Katholytabteil mit einer Katholytlösung, einer reduzierbaren Verbindung, die im Wesentlichen in dem Katholytlösungsmittel gelöst bleibt und aus ihrer reduzierten Form wieder oxidiert werden kann. Die Anolyt- und die Katholytlösung können in zwei sich entsprechenden Behältern aufbewahrt und mit Umwälzpumpen durch das Anoden- und Kathodenabteil zirkuliert werden. Die Katholytlösung kann beispielsweise sechswertiges Brom und die Anolytlösung zweiwertiges Brom enthalten.

Aus der DE-A-1771148 und der US-A-3533848 ist ein System zur Gewinnung elektrischer Energie durch elektrochemische Kombination von Natrium und Schwefel bekannt, dadurch gekennzeichnet, dass es ein für Natriumionen durchgängiges Diaphragma mit benachbarten Räumen für Natrium und Schwefel, einen Behälter zur Lagerung des Natriums außerhalb der Zelle, Leitungen zur Beförderung des Natriums vom Lagerbehälter zur Brennstoffzelle, einen Behälter zur Lagerung des Schwefels außerhalb der Zeilen und Leitungen zur Beförderung des Schwefels vom Lagerbehälter zur Zelle aufweist. Die Zellen können beispielsweise elektrisch in Serie geschaltet sein.

Aus der JP-A-2001118598 ist es bekannt, Natriumschwefelbatterien mit zwei oder mehr Tanks für geschmolzenes Natrium zu betreiben.

Aus der JP-A-2002184456 ist bekannt, eine Natriumschwefelbatterie mit einem externen Lagertank für Schwefel zu betreiben, welcher mit der Batterie fest verbunden ist.

Bei den bekannten Natriumschwefelbatterien und ihren Ausführungen als Flow-Batterie erfolgt die Einspeisung der in den Edukten Natrium und Schwefel gespeicherten Energiemenge und die Entladung durch Umsetzung von Natrium und Schwefel unter Bildung von Natriumsulfid bzw. Natriumpolysulfiden zeitlich und örtlich gekoppelt.

Der Erfindung lag daher die Aufgabe zugrunde, ein verbessertes Verfahren für ein elektrochemisches Kraftwerk mit den Einsatzstoffen Alkali, insbesondere Natrium, und Schwefel zur Verfügung zu stellen. Das elektrochemische Kraftwerk wird in einer bevorzugten Ausführungsform betrieben, indem Natrium und Schwefel getrennt zugeführt werden. Dabei wird Strom erzeugt und Natriumpolysulfid produziert. Das Natriumpolysulfid wird aus dem Kraftwerk abgeführt und recykliert. In einer anschließenden Elektrolyse wird das Natriumpolysulfid wieder eingesetzt und unter Energieverbrauch in Natrium und Schwefel rückgespalten. Das erfindungsgemäße Verfahren gestattet es auch, die Prozessschritte Stromerzeugung und Stromverwertung mit Natriumpolysulfidzersetzung in einer Anlage durchzuführen. Stromerzeugung und Stromverwertung können hinsichtlich Energieernte und Lastgang optimiert werden. Die Energieverwertung kann beispielsweise an Orten hoher Energie Verfügbarkeit stattfinden und Stromerzeugung an Orten eines hohen Energiebedarfs.

Die Erfindung betrifft ein Verfahren zur Speicherung, zum Transport und zur Abgabe elektrochemischer Energie in einem elektrochemischen Kraftwerk, dadurch gekennzeichnet, dass an einem Ort des Energiebedarfs
1.) jeweils wenigstens ein Vorratsbehälter B1 mit hochreinem flüssigem Schwefel und ein Vorratsbehälter B2 mit flüssigem hochreinem Alkalimetall bereitgestellt werden
2.) wenigstens eine elektrochemische Alkalimetall/Schwefelzelle bereitgestellt wird, wobei diese Zelle jeweils mindestens folgende Komponenten umfasst:
   2.1 ein Anodenabteil A für die Aufnahme von flüssigem Alkalimetall
   2.2 ein Kathodenabteil K für die Aufnahme von flüssigem Schwefel, wobei
   2.3 die Abteile A und K durch einen festen Elektrolyten E getrennt sind, der bei der Betriebstemperatur der Zelle für durch Oxidation des Alkalimetalls gebildete Kationen durchlässig ist,
   2.4 Elektroden für den Schluss eines äußeren Stromkreises für den durch die Umsetzung des Alkalimetalls mit dem Schwefel erzeugt elektrischen Strom
3.) Vorratsbehälter B2 mit dem Anodenabteil A und Vorratsbehälter BS mit dem Kathodenabteil K verbunden werden unter Zufuhr von flüssigem Alkalimetall in das Anodenabteil A und flüssigem Schwefel in das Kathodenabteil K
4.) der äußere Stromkreis unter Oxidation des Alkalimetalls, Bildung von Alkalisulfiden im Kathodenabteil K und Stromfluss geschlossen wird,
5.) die im Kathodenabteil gebildeten Alkalisulfide abgezogen und in einem Vorratsbehälter B3 gesammelt werden,
6.) die im Vorratsbehälter B3 gesammelten Alkalisulfide zu einer zweiten elektrochemischen Zelle an einem Ort hoher Energieverfügbarkeit und Elektrolyse in der elektrochemischen Zelle unter Bildung von Schwefel und hochreinem Natrium transportiert werden,
7.) wenigstens einer der in Schritt 6 gewonnenen Komponenten Schwefel und Alkalimetall an einen Ort des Energiebedarfs transportiert und in ein als Stromerzeuger geschaltetes elektrochemisches Kraftwerk eingespeist wird, wobei Schwefel, Alkalimetall und Alkalisulfide jeweils in getrennten, geheizten Vorrats behältern gelagert werden.

Die Betriebstemperatur der elektrochemischen Zelle beträgt vorzugsweise wenigstens 250 °C und liegt vorzugsweise in einem Bereich von 300 °C bis 350 °C.

Die im Kathodenabteil gebildeten Alkalimetallsulfide können Alkalimetallsulfid und/oder die entsprechenden Polysulfide umfassen, insbesondere Polysulfide der Formel M₂Sₓ, worin x eine Zahl > 2 bedeutet, insbesondere Natriumpolysulfide Na₂Sₓ.

Bei der Stromerzeugung im Alkalimetallschwefel-Reaktor wird Alkalimetall im Anodenraum am Elektrolyten E oxidiert, wobei die gebildeten Alkalimetallkationen durch die semipermeable Wand des Elektrolyten E in den Kathodenabteil wandern und sich dort mit dem Schwefel zu Alkalisulfiden umsetzen.

Orte des Energiebedarfs sind insbesondere alle Orte, an denen Energie erforderlich ist und nicht in hinreichendem Maße zur Verfügung steht. Orte hoher Energieverfügbarkeit sind insbesondere Orte, an denen elektrischer Strom kostengünstig und insbesondere umweltschonend erzeugt werden kann, wobei die Erzeugung durch übliche Kraftwerke, aber auch insbesondere durch Solarenergie oder Wasser und Windkraft erzeugt werden kann.

Das erfindungsgemäße Verfahren erlaubt daher den Transport von Alkalimetall, insbesondere Natrium, und Schwefel zum Zwecke der Verstromung in dem erfindungsgemäßen Verfahren über weite Distanzen, beispielsweise via Schiff. So ist der Transport von Natrium und Schwefel von einem für regenerierbare Energien bevorzugten Standort zu einem beispielsweise tausende Kilometer entfernten Verbrauchsstandort und Rücktransport des anfallenden Natriumpolysulfids zur neuerlichen Spaltung energetisch möglich. Hierdurch gelingt es, regenerative Energiequellen gezielt an Orten zu nutzen, an denen Energie im Überschuss erzeugt werden kann. Im Gegenzug kann die durch das Prinzip der Natriumschwefel-Elektrolyse gespeicherte Energie zu Orten transportiert werden, an denen ein entsprechender Bedarf besteht.

In einer bevorzugten Ausführungsform basiert das erfindungsgemäß zu verwendende elektrochemische Kraftwerk auf Reaktorzellen, die in Zahl und Bauart dem jeweiligen Einsatz angepasst sind. In einer bevorzugten Ausführungsform liegt die Zelle des Rohrreaktors vor. Dabei können klassische Elektrolyse-Zellen, ähnlich der Membranzelle bei der Chlor-Alkali-Elektrolyse genutzt werden. Im System Natrium-Schwefel trennt jedoch der feste Elektrolyt E, insbesondere eine Natrium-Ionen leitende Funktionskeramik, die flüssigen Reaktanden. Mehrere Einzelzellen lassen sich zu Modulen zusammenfassen. Zur Optimierung der Leistung werden mehrere durch den Elektrolyten getrennte Zelleinheiten parallel geschaltet. Eine weitere mögliche Zellgeometrie sind röhrenförmige Zellen, in denen Natrium und Schwefel, durch die NatriumIonen leitende Funktionskeramik getrennt, aneinander vorbei strömen. Bei einem vorgegebenen Volumen wird, unabhängig von der Bauart der Zelle, die Optimierung des Oberflächen-Volumenverhältnisses von Elektrolyt zu Reaktanden angestrebt, so dass auch bei Großanlagen eine kompakte Bauart möglich ist und die Leistungsdichte pro Volumen möglichst hoch ist. Unabhängig von der Bauart werden die einzelnen Zellen, die jeweils eine Zellenspannung von rund 2 V vorweisen, in Reihen- oder Parallelschaltung miteinander verbunden. Das so eingestellte Spannungsniveau ergibt sich additiv aus den Spannungen der in Reihe verbunden Zellmodule. Die zugeführte Menge von Natrium und Schwefel aus den Vorratsbehältern, durch die Zellen und zurück in den Natriumpolysulfid Vorratsbehälter B3 wird der Stromerzeugung angepasst. Dabei kann die Produktzuführung und Eduktabführung kontinuierlich bzw. diskontinuierlich erfolgen. Alkalimetall, Schwefel und Alkalimetallpolysulfid werden in getrennten, geheizten Vorratsbehältern, insbesondere Tanks gelagert. Erfindungsgemäß hat die Kraftwerkskapazität keine Begrenzung. Kraftwerksblöcke von > 1 MW, Insbesondere 1 - 1.000 MW sind demnach ohne weiteres möglich. Die Spannung der Kraftwerkseinheit kann nach Umwandlung in Drehstrom in das Stromnetz eingespeist werden. Die Optimierung des elektrochemischen Reaktors strebt ein möglichst großes Oberflächen-Volumenverhältnis der Natrium-Ionen leitenden Funktionskeramik zu dem Volumen der Reaktanden an, so dass auch bei Großanlagen eine kompakte Bauart möglich ist und die Leistungsdichte pro Volumen möglichst hoch ist.

In einer bevorzugten Ausführungsform erfolgt die Zuführung und/oder Abführung des elektrischen Stroms zu den Elektroden und von den Elektroden weg über eine Mehrzahl von gleichmäßig über die Oberfläche der genannten Elektroden verteilten Punkte. In einer weiteren bevorzugten Ausführungsform ist das flüssige Alkalimetall hochreines Natrium, vorzugsweise mit einem maximalen Gehalt an zweiwertigen Kationen kleiner als 3 ppm. In einer weiteren bevorzugten Ausführungsform ist das flüssige Nicht-Metall Schwefel. Die Zelle wird in einem bevorzugten Verfahren vorzugsweise dadurch betrieben, dass das flüssige Alkalimetall mit Hilfe eines mit Überdruck eingeführten Inertgases zirkuliert wird.

Der Elektrolyt besteht in einer bevorzugten Ausführungsform aus β-Aluminiumoxid oder β" Aluminiumoxid, welches vorzugsweise stabilisiert wird, vorzugsweise mit MgO oder Li₂O.

In einer bevorzugten Ausführungsform wird der flüssige Schwefel im Kathodenabteil mit einem Leitzusatz versetzt. Bevorzugte Leitzusätze sind Selen, Tetracyanoethylen, Graphite und Ruß.

### Beispiele

### Beispiel 1:

### A) Stromerzeugung

### Apparatur

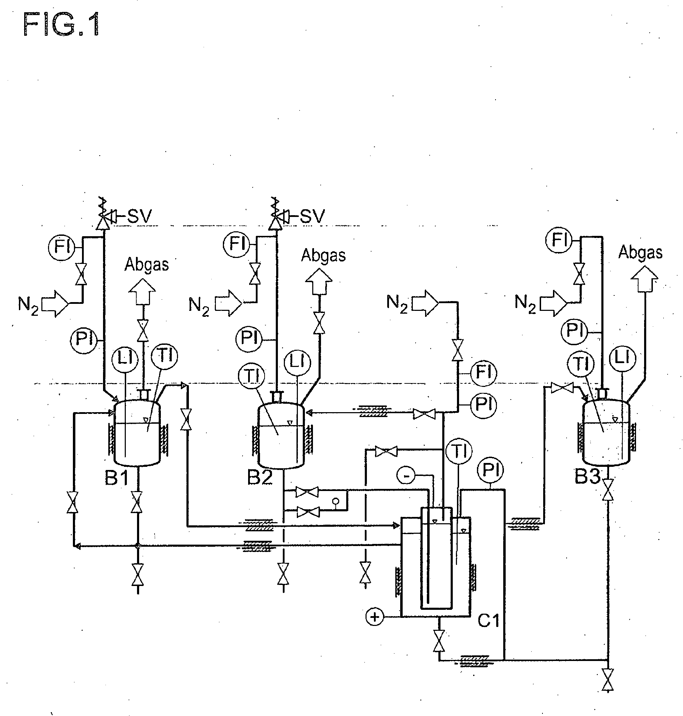

Es wurde die in Abbildung 1 als Fließbild gezeigte Laborapparatur eingesetzt.

Die Apparatur wurde mittels elektrischen Heizbändern und einer entsprechenden thermischen Isolierung auf 300 °C gehalten.

Die Apparatur hat 3 Vorratsgefäße B1, B2 mit einem nutzbaren Volumen von je 2,5 Litern und B3 mit einem nutzbaren Volumen von 4 Litern.

B1 dient zur Aufnahme von flüssigem Schwefel, B2 zur Aufnahme von Natrium und B3 zur Aufnahme des Schwefels und gebildeten Polysulfids aus B2. C1 ist die Elektrolysezelle. An den mit N₂ gekennzeichneten Stellen kann Stickstoff über Ventile in die Apparatur eingeführt werden. An den mit SV gekennzeichneten Stellen befinden sich Sicherheitsventile. An den gekennzeichneten Stellen befinden sich Messinstrumente zur Bestimmung von Durchfluss (FI), Druck (PI), Stand (LI) und Temperatur (TI).

Die Behälter haben eine Schnellverschlussöffnung im Deckel für das Einfüllen von Feststoff. Der Elektrolysereaktor C1, geteilt mit einem keramischen Ionen leitenden Festkörperelektrolyten (200 cm², 2 mm dick), ist durch eine feste Verrohrung mit Absperrventilen mit diesen 3 Vorratsgefäßen verbunden.

Alle Bauteile bestehen aus Edelstahl. Um einen Kurzschluss zu vermeiden sind die unterschiedlich gepolten Leitungen und Apparateteile durch geeignete elektrische Isolierungen potentialgetrennt gehaltert.

Positiv gepolt ist der Schwefel führende Teil der Zelle und die dort angeschlossenen Leitungen und Behälter B1 und B3. Negativ gepolt ist der Natrium führende Teil der Zelle und die dort angeschlossenen Leitungen und der Behälter B2.

Messstellen sind vorzugsweise eingerichtet zu:
- Temperatur und Druck in den Behältern B1, B2, B3 und dem Elektrolysereaktor C1,
- Füllstand in den Behältern B1, B2, B3
- Spülgasmengenstrom in den Behältern B1, B2, B3 und dem Elektrolysereaktor C1,
- Zellenspannung und Elektrolysestrom von Elektrolysereaktor C1.

### Elektrochemische Stromerzeugung

In den Behälter B1 wurde Schwefel als Pulver mit einem Leitzusatz aus 1 % Selen und Tetracyanoethylen eingefüllt und dort unter Inertgas aufgeschmolzen.

In den Behälter B2 wurde hochreines Natrium eingefüllt und dort unter Inertgas aufgeschmolzen.

Der negativ gepolte Elektrodenraum des Elektrolysereaktors wurde bis zum Überlauf mit flüssigem Natrium gefüllt. Der positiv gepolte Elektrodenraum des Elektrolysereaktors wurde bis zum Überlauf mit flüssigem Schwefel gefüllt. Beim Überlauf trieb der von B1 zu B3 strömende Stickstoffstrom den Schwefel (später Polysulfid) aus dem Reaktor in den Behälter B3. Die Füllstände der Behälter wurden danach durch Nachfüllen korrigiert. Die Behälter B1 und B2 waren vor Beginn der elektrochemischen Stromerzeugung zu 80 % gefüllt, der Behälter B3 zu 10 %.

Vor dem Zuschalten der Elektrolyse wurde das Bodenventil des Behälters B1 (Schwefel) geschlossen und das über eine Drosselblende führende Bodenventil des Behälters B2 (Natrium) geöffnet und das Natriumventil im Bypass geschlossen.

Durch Zuschalten eines zwischen Plus- und Minuspol geschalteten regelbaren elektrischen Widerstandes wurde ein Elektrolysestrom von 0,1 bis 40 Ampere dem elektrochemischen Reaktor entnommen. Das elektrochemische Reaktionspotential wurde von Zeit zu Zeit stromlos mit offenen Klemmen bestimmt.

Wenn das elektrochemische Reaktionspotential unter den Wert von 2,00 Volt gefallen war, wurde von Hand das Bodenventil des Behälters B1 geöffnet und flüssiger Schwefel in den Reaktor C1 diskontinuierlich zugefahren. Der Natriumraum des Elektrolysereaktors wurde durch den selbsttätigen Zufluss aus dem Vorratsbehälter B2 gefüllt gehalten.

Im Laufe des Versuches verminderten sich die Füllstände in den Vorratsbehältern B1 und B2, während der Füllstand in B3 anstieg.

Während des Versuches, der über 100 Stunden lief, wurden 2000 g Natriummetall und 4400 g Schwefel umgesetzt. Dabei wurden in Summe 2330 Ah elektrischer Ladung abgegeben. Die mittlere Zellspannung war 1,91 Volt. Die Analyse des in B3 gesammelten Produktes entsprach der Zusammensetzung Na₂S_{2,9}.

### B) Elektrolyse von Natriumpolysulfid

Die Elektrolyseeinrichtung entsprach dem apparativen Aufbau von Beispiel A) zur Stromerzeugung. In den Behälter B3 wurden 6400 g Natriumpolysulfid der Zusammensetzung Na₂S_{2,9} eingesetzt. Das Bodenventil des Behälters B1 (Schwefel) wurde geschlossen und das über eine Drosselblende führende Bodenventil des Behälters B2 (Natrium) wurde geöffnet und das Natriumventil im Bypass geschlossen.

Durch Zuschalten eines zwischen Plus- und Minuspol geschalteten regelbaren elektrischen Elektrolysenetzgerätes wurde ein Elektrolysestrom von 0,1 bis 40 Ampere, Mittelwert 20 Ampere dem elektrochemischen Reaktor zugeführt. Das elektrochemische Reaktionspotential wurde von Zeit zu Zeit stromlos mit offenen Klemmen bestimmt.

Wenn das elektrochemische Reaktionspotential über den Wert von 2,07 Volt gestiegen war, wurde von Hand das Bodenventil des Behälters B3 geöffnet und flüssiges Polysulfid in den Reaktor C1 diskontinuierlich zugefahren. Das im Natriumraum des Elektrolysereaktors gesammelte Natrium floss selbsttätig in den Vorlagebehälter B2 zurück.

Im Laufe des Versuches stiegen die Füllstände in den Vorlagen B1 und B2 an, während der Füllstand in B3 abnahm.

Während des Versuches, der über 100 Stunden ging wurden aus 6400g Polysulfid 2000g Natriummetall erzeugt und 4400g Schwefel erhalten. Dabei wurden in Summe 2330 Ah elektrischer Ladung zugeführt. Die mittlere Zellspannung war 2,25 Volt.

### Versuchszyklen

Die Versuche mit der Abfolge elektrochemische Energieerzeugung und elektrochemische Energieverwertung mittels Natriumpolysulfid Elektrolyse wurde 10-mal reproduziert, ohne eine Änderung des Reaktionsverhaltens zu beobachten.

### Beispiel 2:

### 2.1 Kraftwerk

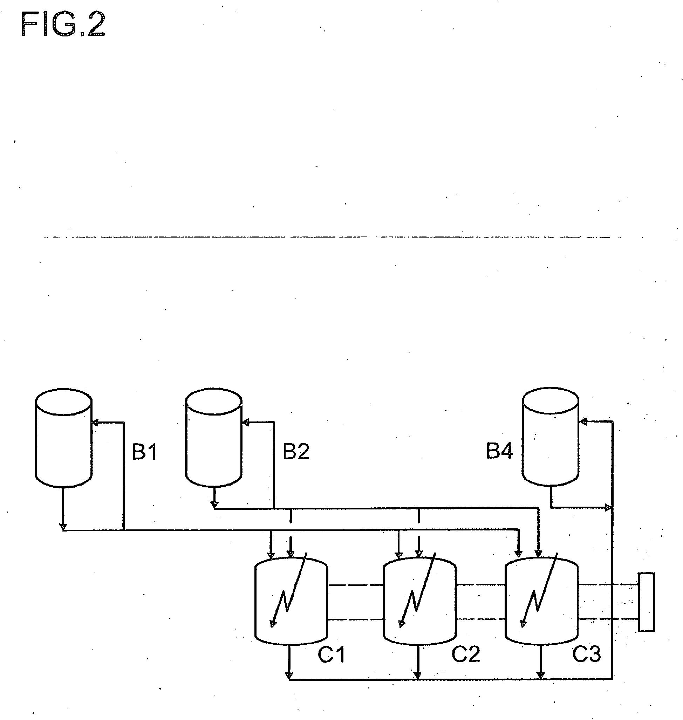

Es wird ein 1000 MW-Speicherkraftwerk ausgelegt, das eine Speicherkapazität für 50 Volllaststunden hat. Das in Abbildung 2 gezeigte Fließbild zeigt dieses Kraftwerk schematisch.

Alle Produkt führenden Apparate und Rohrleitungen werden mittels elektrischer Zusatzheizungen und einer entsprechenden thermischen Isolierung auf 300 °C gehalten. Es gibt die drei Vorratstanklager B1 und B2 mit einem Volumen von je 22000 m³ und einen weiteren Tank B3 mit 45.000 m³. Die Behälter werden aus Tankschiffen mit flüssigem Natrium (B2) bzw. flüssigem Schwefel (B1) betankt. Es gibt beispielsweise 3 Elektrolysereaktorblöcke C1, C2 und C3 mit einer elektrischen Nennleistung von je 334 MW. Diese Reaktorblöcke bestehen aus modular aufgebauten keramischen Reaktoren mit Ionen leitenden Festkörperelektrolyten.

Ein 1000 MW-Speicherkraftwerk hat ein Reaktorvolumen von insgesamt 5000 m³ und eine Elektrodenoberfläche von insgesamt 500000 m². Die einzelnen Reaktoren werden über ein potentialgetrenntes Verteilersystem mit Natrium bzw. Schwefel versorgt. Das bei der Reaktion gebildete Polysulfid wird potentialgetrennt gesammelt und dem Tanklager B3 zugeführt.

Um einen Kurzschluss zu vermeiden werden die unterschiedlich gepolten Leitungen und Apparateteile durch geeignete elektrische Isolierungen potentialgetrennt gehaltert. So wird vorzugsweise der Vorratsbehälter BA mittels einer Potentialtrennung von der Zelle elektrisch getrennt.

Positiv gepolt ist der Schwefel führende Teil der Elektrolysereaktoren. Negativ gepolt ist der Natrium führende Teil der Elektrolysereaktoren.

### 2.2 Elektrochemische Stromerzeugung

Die grundsätzlich dem Aufbau gemäß 2.1) entsprechende Anlage wird durch Zuführung von Strom an einem Ort mit Energieüberschuss zur Speicherung verwendet.

Das elektrochemische Reaktionspotential wird mit einer gesteuerten Zudosierung von Schwefel auf 2,00 Volt pro Einzelzelle gehalten. Durch elektrische Reihen- und Parallelschaltung werden daraus eine Gesamtspannung auf der Gleichstromseite von 1000V und einem Gesamtstrom pro Reaktorblock von 334 kA.

Mit gesteuerten Wechselrichtern wird der Gleichstrom zu Drehstrom umgeformt. Der Drehstrom wird dann mit den Drehstromtransformatoren auf Netzspannung hochgespannt.

### Natriumpolysulfid Elektrolyse

Durch Zuschalten von geregelten Gleichrichtern kann Energie aus dem Netz in den Elektrolysezellen verwertet werden. Dabei wird Polysulfid in die Reaktoren gespeist und Natrium und Schwefel erhalten. Die betreffenden Tanklager werden dabei gefüllt bzw. geleert.

Der Betrag der Gleichströme ist so groß wie bei der Energieerzeugung. Die Ladespannung ist um ca. 0,2 höher als die Entladespannung der Energieerzeugung.

### Ladezyklen

Das System ist langzeitstabil und zyklenstabil.

### CO₂-Vermeidungspotenzial

Vergleicht man das Speicherkraftwerk aus Beispiel 2 mit einem konventionellen Steinkohlekraftwerk, so ergibt sich bei einer Nennleistung von 700 MW eine Laufzeit von 71 h bis zur Energieäquivalenz (= 50 GWh). Für die Erzeugung der 50 GWh sind bei einem Wirkungsgrad von 38 % und einem spezifischen Kohleverbrauch von 323g/kWh ca. 16.180 to Steinkohle erforderlich. Dem entspricht eine CO2-Menge von 48.540 to CO₂, die pro Stromerzeugungszyklus mit dem elektrochemischen Speicherkraftwerk eingespart wird - solange es ausschließlich aus regenerativen Energiequellen gespeist wird.

Selbst der Transport der Reaktanden über Strecken von mehreren tausend Kilometern macht Sinn. So können Natrium und Schwefel an Orten hoher Energieverfügbarkeit erzeugt und gezielt zu Orten mit hohem Energiebedarf transportiert werden. Beispielsweise können die Reaktanden mittels Photovoltaik in Nordafrika erzeugt werden und anschließend per Hochseetransport in einen Hochseehafen verschifft werden. Bei einer Transportstrecke von 3.000 km und mit einem spezifischen Ölverbrauch eines Hochseetankers von 1,6 g Schweröl/t-Fracht/km ergibt sich für eine Beiladung von 50.000 twd ein Schwerölverbrauch von 244 to. Mit einem kinetischen Wirkungsgrad des Verbrennungsmotors von 25 % entspricht das einem Energieverbrauch von 684 MWh. Setzt man für die 50.000 twd Natrium und Schwefel einen konservativen spezifischen Energieinhalt von 123 Wh/kg an, so entspricht die gesamte Beiladung einem Energieinhalt von 6.241 MWh. Nach 3.000 km Transportstrecke sind demnach nur 11 % der ursprünglich in den Reaktanden gespeicherten Energie durch den Transport verbraucht.

## Patentansprüche

1. Verfahren zur Speicherung, zum Transport und zur Abgabe elektrochemischer Energie unter Verwendung eines elektrochemischen Reaktors mit den Reaktanden Alkalimetall und Schwefel in einem elektrochemischen Kraftwerk, **dadurch gekennzeichnet, dass** an einem Ort des Energiebedarfs
1.) jeweils wenigstens ein Vorratsbehälter B1 mit hochreinem flüssigem Schwefel und ein Vorratsbehälter B2 mit flüssigem hochreinem Alkalimetall bereitgestellt werden
2.) wenigstens ein elektrochemischer Alkalimetall/Schwefelreaktor bereitgestellt wird, wobei dieser Reaktor jeweils mindestens folgende Komponenten umfasst:
2.1 ein negativ gepoltes Abteil A für die Aufnahme von flüssigem Akalimetall
2.2 ein positiv gepoltes Abteil K für die Aufnahme von flüssigem Schwefel, wobei
2.3 die Abteile A und K durch einen festen Elektrolyten E getrennt sind, der bei der Betriebstemperatur der Zelle für durch Oxidation des Alkalimetalls gebildete Kationen durchlässig ist,
2.4 Elektroden für den Schluss eines äußeren Stromkreises für den durch die Umsetzung des Alkalimetalls mit dem Schwefel erzeugten elektrischen Strom
3.) Vorratsbehälter B2 mit dem negativ gepolten Abteil A und Vorratsbehälter B1 mit dem positiv gepolten Abteil K verbunden werden unter Zufuhr von flüssigem Alkalimetall in das negativ gepolte Abteil A und flüssigem Schwefel in das positiv gepolte Abteil K
4.) der äußere Stromkreis unter Oxidation des Alkalimetalls, Bildung von Alkalisulfiden im Kathodenabteil K und Stromfluss geschlossen wird,
5.) die im Kathodenabteil gebildeten Alkalisulfide abgezogen und in einem Vorratsbehälter B3 gesammelt werden,
6.) die Im Vorratsbehälter B3 gesammelten Alkalisulfide zu einer zweiten elektrochemischen Zelle an einem Ort hoher Energieverfügbarkeit transportiert und in der elektrochemischen Zelle unter Bildung von Schwefel und Alkalimetall, insbesondere hochreinem Natrium, elektrolysiert werden,
7.) wenigstens einer der in Schritt 6 gewonnenen Komponenten Schwefel und Alkalimetall an einen Ort des Energiebedarfs transportiert und in ein als Stromerzeuger geschaltetes Alkallmetallschwefel-Kraftwerk eingespeist wird,
wobei Schwefel, Alkalimetall und Alkalisulfide jeweils in getrennten, geheizten Vorratsbehältern gelagert werden.

2. Verfahren nach Anspruch 1, **dadurch gekennzeichnet, dass** die Zuführung und/oder Abführung des elektrischen Stroms zu den Elektroden und von den Elektroden weg über eine Mehrzahl von gleichmäßig über die Oberfläche der genannten Elektroden verteilten Punkte erfolgt.

3. Verfahren nach wenigstens einem der vorhergehenden Ansprüche, **dadurch gekennzeichnet, dass** das flüssige Alkalimetall hochreines Natrium ist.

4. Verfahren nach wenigstens einem der vorhergehenden Ansprüche, **dadurch gekennzeichnet, dass** der Vorratsbehälter B2 mittels einer Potentialtrennung von der Zelle elektrisch getrennt ist.

5. Verfahren nach wenigstens einem der vorhergehenden Ansprüche, **dadurch gekennzeichnet, dass** das flüssige Alkalimetall-Metall mit Hilfe eines mit Überdruck eingeführten Inertgases zirkuliert wird.

6. Verfahren nach wenigstens einem der vorhergehenden Ansprüche, **dadurch gekennzeichnet, dass** im Kathodenabteil flüssiger Schwefel und Natriumpolysulfid enthalten sind.

7. Verfahren nach wenigstens einem der vorhergehenden Ansprüche, **dadurch gekennzeichnet, dass** im Kathodenabteil flüssiger Schwefel und flüssiges Natriumpolysulfid enthalten sind.

8. Verfahren nach wenigstens einem der vorhergehenden Ansprüche, **dadurch gekennzeichnet, dass** als Elektrolyt E β-Aluminiumoxid, oder β"Aluminiumoxid verwendet werden, die gegebenenfalls stabilisiert sind, vorzugsweise mit MgO oder Li₂O.

9. Verfahren nach wenigstens einem der vorhergehenden Ansprüche, **dadurch gekennzeichnet, dass** eine Betriebstemperatur von wenigstens 300 °C eingehalten wird.

10. Verfahren nach wenigstens einem der vorhergehenden Ansprüche, **dadurch gekennzeichnet, dass** im Kathodenabteil ein Leitzusatz verwendet wird.

11. Verfahren nach wenigstens einem der vorhergehenden Ansprüche, **dadurch gekennzeichnet, dass** die Zelle als Rohrreaktor vorliegt.

12. Verfahren nach wenigstens einem der vorhergehenden Ansprüche, **dadurch gekennzeichnet, dass** das flüssige Alkalimetall hochreines Natrium ist mit einem maximalen Gehalt an zweiwertigen Kationen kleiner als 3 ppm.

13. Verfahren nach wenigstens einem der vorhergehenden Ansprüche, **dadurch gekennzeichnet, dass** das bei der Entladung gebildete Alkalimetallpolysulfid in wenigstens einen Vorratsbehälter eingebracht wird, dieser Vorratsbehälter von der zur Entladung und Strombereitstellung verwendeten Anlage abgekoppelt wird und an einem räumlich getrennten Ort durch Zuführung elektrischer Energie in einer zweiten Zelle in Alkalimetall und Schwefel aufgespalten wird, wobei die zweite Zelle der Bauart nach der ersten Zelle entsprechen kann.

14. Verfahren nach Anspruch 13, **dadurch gekennzeichnet, dass** der zur Elektrolyse des Natriumpolysulfids erforderliche Strom an einem räumlich getrennten Ort mittels Solar-, Wind-, Wasserkraftwerken oder Geothermie erzeugt wird.

## Claims

1. A method of storing, transporting and supplying electrochemical energy using an electrochemical reactor with the reactants alkali metal and sulfur in an electrochemical power station, wherein, at a location where energy is required,
1.) at least one stock container B1 comprising high-purity liquid sulfur and at least one stock container B2 comprising liquid high-purity alkali metal are provided,
2.) at least one electrochemical alkali metal/sulfur reactor is provided, with this reactor comprising at least the following components:
2.1 a negative compartment A for accommodating liquid alkali metal,
2.2 a positive compartment K for accommodating liquid sulfur, where
2.3 the compartments A and K are separated by a solid electrolyte E which at the operating temperature of the cell is permeable to cations formed by oxidation of the alkali metal,
2.4 electrodes for closing an external current circuit for the electric power generated by the reaction of the alkali metal with the sulfur,
3.) stock container B2 is connected to the negative compartment A and stock container B1 is connected to the positive compartment K with introduction of liquid alkali metal into the negative compartment A and of liquid sulfur into the positive compartment K,
4.) the external current circuit is closed, resulting in oxidation of the alkali metal, formation of alkali metal sulfides in the cathode space K and flow of electric current,
5.) alkali metal sulfides formed in the cathode compartment are taken off and collected in a stock container B3,
6.) alkali metal sulfides collected in the stock container B3 are transported to a second electrochemical cell at a location having a high energy availability and are electrolyzed in the electrochemical cell to form sulfur and alkali metal, in particular high-purity sodium,
7.) at least one of the components sulfur and alkali metal obtained in step 6 is transported to a location where energy is required and fed into an alkali metal-sulfur power station configured as power generator,
where sulfur, alkali metal and alkali metal sulfides are each stored in separate, heated stock containers.

2. The method according to claim 1, wherein the supply and/or discharge of electric current to the electrodes and away from the electrodes is effected via a plurality of points distributed uniformly over the surface of said electrodes.

3. The method according to at least one of the preceding claims, wherein the liquid alkali metal is high-purity sodium.

4. The method according to at least one of the preceding claims, wherein the stock container B2 is electrically separated from the cell by means of a separation of potentials.

5. The method according to at least one of the preceding claims, wherein the liquid alkali metal is circulated by means of an inert gas introduced under superatmospheric pressure.

6. The method according to at least one of the preceding claims, wherein liquid sulfur and sodium polysulfide are comprised in the cathode compartment.

7. The method according to at least one of the preceding claims, wherein liquid sulfur and liquid sodium polysulfide are comprised in the cathode compartment.

8. The method according to at least one of the preceding claims, wherein β-aluminum oxide or β"-aluminum oxide, which may be stabilized, preferably by means of MgO or Li₂O, is used as electrolyte E.

9. The method according to at least one of the preceding claims, wherein an operating temperature of at least 300°C is maintained.

10. The method according to at least one of the preceding claims, wherein a supporting electrolyte is used in the cathode compartment.

11. The method according to at least one of the preceding claims, wherein the cell is present as a tube reactor.

12. The method according to at least one of the preceding claims, wherein the liquid alkali metal is high-purity sodium having a maximum content of divalent cations of less than 3 ppm.

13. The method according to at least one of the preceding claims, wherein the alkali metal polysulfide formed during discharge is introduced into at least one stock container, this stock container is disconnected from the plant used for discharge and provision of electric power and the alkali metal polysulfide is redissociated into alkali metal and sulfur by introduction of electric energy in a second cell at a physically separate location, with the second cell being able to correspond in terms of construction to the first cell.

14. The method according to claim 13, wherein the electric power required for electrolysis of the sodium polysulfide is generated at a physically separate location by means of solar, wind or hydroelectric power stations or by geothermal means.

## Revendications

1. Procédé de stockage, de transport et de libération d'énergie électrochimique utilisant un réacteur électrochimique avec les réactifs métal alcalin et soufre dans une centrale électrochimique, **caractérisé en ce qu'**à un emplacement de demande d'énergie
1) respectivement au moins un contenant de stockage B1 contenant du soufre liquide hautement pur et un contenant de stockage B2 contenant un métal alcalin hautement pur liquide sont préparés,
2) au moins un réacteur à métal alcalin/soufre électrochimique est préparé, ce réacteur comprenant à chaque fois au moins les composants suivants :
2.1 un compartiment à polarisation négative A pour la réception de métal alcalin liquide,
2.2 un compartiment à polarisation positive K pour la réception de soufre liquide,
2.3 les compartiments A et K étant séparés par un électrolyte solide E, qui est perméable aux cations formés par l'oxydation du métal alcalin à la température d'exploitation de la cellule,
2.4 des électrodes pour la formation d'un circuit extérieur pour le courant électrique généré par la réaction du métal alcalin avec le soufre,
3) le contenant de stockage B2 est raccordé avec le compartiment à polarisation négative A et le contenant de stockage B1 est raccordé avec le compartiment à polarisation positive K avec introduction de métal alcalin liquide dans le compartiment à polarisation négative A et de soufre liquide dans le compartiment à polarisation positive K,
4) le circuit extérieur est fermé par oxydation du métal alcalin, formation de sulfures alcalins dans le compartiment cathodique K et passage du courant,
5) les sulfures alcalins formés dans le compartiment cathodique sont extraits et recueillis dans un contenant de stockage B3,
6) les sulfures alcalins recueillis dans le contenant de stockage B3 sont transportés dans une seconde cellule électrochimique à un emplacement de disponibilité énergétique plus élevée et électrolysés dans la cellule électrochimique avec formation de soufre et de métal alcalin, notamment de sodium hautement pur,
7) au moins un des composants soufre et métal alcalin obtenus à l'étape 6 est transporté à un emplacement de demande d'énergie et stocké dans une centrale électrique métal alcalin-soufre configurée sous la forme d'un générateur de courant,
le soufre, le métal alcalin et les sulfures alcalins étant chacun entreposés dans des contenants de stockage chauffés séparés.

2. Procédé selon la revendication 1, **caractérisé en ce que** l'introduction du courant électrique dans les électrodes et/ou le déchargement du courant électrique des électrodes a lieu par une pluralité de points répartis uniformément sur la surface desdites électrodes.

3. Procédé selon au moins l'une quelconque des revendications précédentes, **caractérisé en ce que** le métal alcalin liquide est du sodium hautement pur.

4. Procédé selon au moins l'une quelconque des revendications précédentes, **caractérisé en ce que** le contenant de stockage B2 est séparé électriquement par une séparation de potentiel de la cellule.

5. Procédé selon au moins l'une quelconque des revendications précédentes, **caractérisé en ce que** le métal alcalin liquide circule à l'aide d'un gaz inerte introduit à une surpression.

6. Procédé selon au moins l'une quelconque des revendications précédentes, **caractérisé en ce que** du soufre liquide et du polysulfure de sodium sont contenus dans le compartiment cathodique.

7. Procédé selon au moins l'une quelconque des revendications précédentes, **caractérisé en ce que** du soufre liquide et du polysulfure de sodium liquide sont contenus dans le compartiment cathodique.

8. Procédé selon au moins l'une quelconque des revendications précédentes, **caractérisé en ce que** de l'oxyde d'aluminium β ou de l'oxyde d'aluminium β" est utilisé en tant qu'électrolyte E, qui est éventuellement stabilisé, de préférence avec MgO ou Li₂O.

9. Procédé selon au moins l'une quelconque des revendications précédentes, **caractérisé en ce qu'**une température d'exploitation d'au moins 300 °C est maintenue.

10. Procédé selon au moins l'une quelconque des revendications précédentes, **caractérisé en ce qu'**un additif conducteur est utilisé dans le compartiment cathodique.

11. Procédé selon au moins l'une quelconque des revendications précédentes, **caractérisé en ce que** la cellule se présente sous la forme d'un réacteur tubulaire.

12. Procédé selon au moins l'une quelconque des revendications précédentes, **caractérisé en ce que** le métal alcalin liquide est du sodium hautement pur, ayant une teneur maximale en cations bivalents de moins de 3 ppm.

13. Procédé selon au moins l'une quelconque des revendications précédentes, **caractérisé en ce que** le polysulfure de métal alcalin formé lors du déchargement est introduit dans au moins un contenant de stockage, ce contenant de stockage est découplé de l'unité utilisée pour le déchargement et la préparation du courant, et clivé en métal alcalin et soufre à un emplacement séparé dans l'espace par introduction d'énergie électrique dans une seconde cellule, la seconde cellule pouvant être du même type que la première cellule.

14. Procédé selon la revendication 13, **caractérisé en ce que** le courant nécessaire pour l'électrolyse du polysulfure de sodium est généré à un emplacement séparé dans l'espace par des centrales solaires, éoliennes, hydroélectriques ou par géothermie.
